(19) **Europäisches Patentamt European Patent Office Office européen des brevets**

(11) **EP 1 255 357 B1**

(12) **EUROPEAN PATENT SPECIFICATION**

(45) Date of publication and mention
of the grant of the patent:
**05.11.2008 Bulletin 2008/45**

(51) Int Cl.:
*H03M 1/06* [(2006.01)]

(21) Application number: **02100436.1**

(22) Date of filing: **30.04.2002**

(54) **Correction of operational amplifier gain error in pipelined analog to digital converters**

Korrektion der Verstärkungsfehler des Operationsverstärkers in Fliessband-Analog-Digital-Wandler

Correction de l'erreur de gain des amplificateurs opérationnels aux convertisseurs analogique-numérique cascadés

(84) Designated Contracting States:
**DE FR GB**

(30) Priority: **02.05.2001 US 847612**

(43) Date of publication of application:
**06.11.2002 Bulletin 2002/45**

(73) Proprietor: **Texas Instruments Incorporated Dallas, Texas 75251 (US)**

(72) Inventor: **ALI, Ahmed
NJ 08502, New Jersey (US)**

(74) Representative: **Holt, Michael et al
Texas Instruments Limited
European Patents Department
800 Pavilion Drive
Northampton NN4 7YL (GB)**

(56) References cited:
**US-B1- 6 222 471**

• **ALI A M A ET AL: "Correction of operational amplifier gain error in pipelined A/D converters" ISCAS 2001. PROCEEDINGS OF THE 2001 IEEE INTERNATIONAL SYMPOSIUM ON CIRCUITS AND SYSTEMS. SYDNEY, AUSTRALIA, MAY 6 - 9, 2001, IEEE INTERNATIONAL SYMPOSIUM ON CIRCUITS AND SYSTEMS, NEW YORK, NY: IEEE, US, vol. 1 OF 5, 6 May 2001 (2001-05-06), pages 568-571, XP010541493 ISBN: 0-7803-6685-9**
• **SIRAGUSA E J ET AL: "Gain error correction technique for pipelined analogue-to-digital converters" ELECTRONICS LETTERS, IEE STEVENAGE, GB, vol. 36, no. 7, 30 March 2000 (2000-03-30), pages 617-618, XP006015054 ISSN: 0013-5194**
• **SUNG-UNG KWAK ET AL: "A 15 b 5 MSample/s Low-Spurious CMOS ADC" 1997 IEEE INTERNATIONAL SOLID-STATE CIRCUITS CONFERENCE. DIGEST OF TECHNICAL PAPERS. ISSCC. FIRST EDITION VOL.40 (CAT. NO.97CH36014), 1997 IEEE INTERNATIONAL SOLIDS-STATE CIRCUITS CONFERENCE. DIGEST OF TECHNICAL PAPERS, SAN FRANCISCO, CA, USA, 6-8 FE, pages 146-147, 445, XP002263874 1997, New York, NY, USA, IEEE, USA ISBN: 0-7803-3721-2**

**Description**

BACKGROUND OF THE INVENTION

Pipelined analog-to-digital converters (ADCs) are well known in the art. A typical pipelined ADC includes a plurality of ADC stages in which each ADC stage converts a portion of an analog input signal into one or more digital bits. The first ADC stage receives the analog input signal and provides two outputs, the first output includes one or more digital bits and the second output is an analog residue voltage. The one or more digital bits represent the portion of the analog input signal that has been converted into a digital format. The analog residue voltage represents the amount of the analog input signal remaining after the portion converted into the one or more digital bits by the ADC stage has been removed. Each subsequent ADC stage receives the analog residue voltage from the preceding ADC stage and converts a portion of it into one or more digital bits. The ADC stage then removes that portion converted into the digital format from the received input analog residue signal and provides an output analog residue signal to the next adjacent stage. Typically, the first ADC stage in a pipelined ADC provides the most significant bit(s) and the last stage provides the least significant bit(s). The digital bits from each ADC stage taken together represent the digital value of the input signal provided to the ADC.

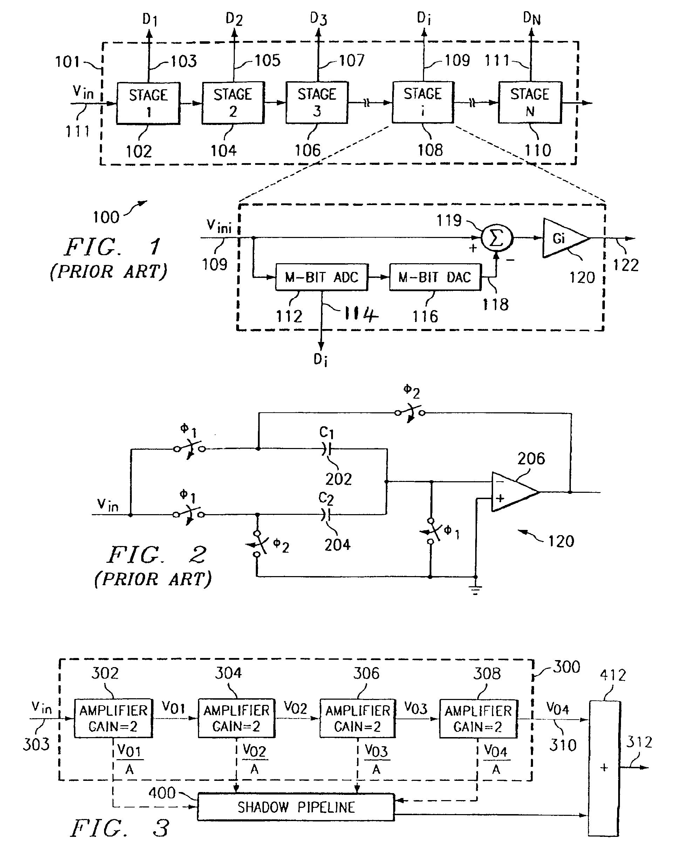

Figure 1 illustrates a typical prior art pipeline ADC 100 having a main pipeline 101 that includes a plurality of N stages 102, 104, 106, 108, and 110. The first stage 102 receives an input signal, Vin, on input line 111. Each stage 102-110 provides one or more digital output bits on lines 103-111 respectively. Stage 108 is shown in more detail as an exemplary ADC stage.

Stage 108 includes a M-bit ADC 112 that receives the input signal $v_{in}$ via line 109. The input signal $V_{in}$ may be either the analog input signal or a residue signal from a preceding stage. The M-bit ADC 112 provides M-bits as an output digital signal on line 114. A M-bit digital-to-analog-converter 116 also reads the M-bit digital output and provides an analog voltage on line 118 that corresponds to the M-bit word provided by ADC 112. A subtraction module 119 subtracts the analog voltage on line 118 from the input voltage $V_{in}$ on line 109. The resulting difference is the residue of the input signal remaining after the portion of the input voltage converted by the ADC stage 112 has been removed. An amplifier 120 amplifies the residue voltage, wherein the amplifier has a gain equal to $2^M$, or in some cases $2^{M-1}$. The amplified residue signal is provided to the next adjacent ADC stage in the pipeline via line 122.

In theory the pipelined ADC 100 should provide a nearly perfect digital representation of the input signal. However, in practice the components and amplifiers used in the pipelined ADC are not ideal. For example the operational amplifiers (op-amps) used in the amplifier modules in each ADC stage have a finite open-loop gain. Because of the finite gain, each amplifier module has a gain that is not $2^M$. Therefore, the residue signal provided by the amplifier will not accurately reflect the amount of the analog signal after the digitized portion has been removed therefrom. In addition to amplifying and promulgating the errors form preceding stages, each stage will also add a finite gain error to the overall error that will be further amplified by the down-stream amplifiers in the main pipeline as well.

Fig. 2 is a typical op-amp circuit configured and arranged to function as the amplifier 120 depicted in Fig. 1. The gain of the amplifier is given by:

$$V_{out} = \frac{V_{in} * G}{1 + \frac{G}{A}} \Rightarrow V_{out} \approx V_{in} * G\left(1 - \frac{G}{A}\right) \tag{1}$$

Where the nominal gain of the amplifier, G, is equal to (C1+C2)/C2. As illustrated by equation (1) however the error term G/A reduces the actual gain of the amplifier. If the open-loop gain, A, is not large enough such that this error term is insignificant, then the actual gain of the amplifier stage will be smaller than expected. Consequently, the residue signal will be smaller than anticipated and each subsequent analog to digital conversion of the residue signal will result in an inaccurate output. As noted above, this inaccurate output will be amplified and promulgated by each subsequent ADC stage. Each ADC stage will also add to the overall error due to the finite gain errors inherent in each of the amplifier modules comprising the ADC stages. Therefore, as the residue signal propagates from stage to stage, the error from the upstream ADC stages is amplified and added to by each downstream ADC stage. Because of the size constraints and the processing required when making a pipelined ADC, the open loop gains of the op-amps often have a value of one-thousand (1000) or less and therefore the finite gain errors cannot be ignored.

Therefore it would be advantageous to provide a pipelined ADC that has reduced errors caused by the finite gain of the operational amplifiers used within the amplifier modules of the pipelined ADC.

US patent number 6222471 describes a digital self calibration scheme for pipelined AD converters. The scheme can correct for capacitor mismatch, capacitor non-linearity, amplifier gain and amplifier non-linearity.

BRIEF SUMMARY OF THE INVENTION

The present invention provides apparatus for compensating amplifier gain error in a pipelined analog to digital converter, as set forth in the appended claims.

BRIEF DESCRIPTION OF THE SEVERAL VIEWS OF THE DRAWING

The invention will be more fully understood by reference to the following Detailed Description of the Invention in conjunction with the drawings of which:

Fig. 1 is a block diagram of a prior art pipeline analog to digital converter;
Fig. 2 is a schematic circuit diagram of a prior art switched capacitor amplifier used in the pipeline analog to digital converter depicted in Fig. 1;
Fig. 3 is a functional block diagram of one embodiment of a pipeline analog to digital converter with an error correcting portion and a shadow pipeline according to the present invention;
Fig. 4 is a functional block diagram illustrating an embodiment of the functional block diagram depicted in Fig. 3;
Fig. 5 is a functional block diagram illustrating another embodiment of the functional block diagram depicted in Fig. 3;
Fig. 6 is a functional block diagram illustrating another embodiment of the functional block diagram depicted in Fig. 3;
Fig. 7 is a functional block diagram illustrating another embodiment of the functional block diagram depicted in Fig. 3;
Fig. 8 is a functional block diagram depicting a shadow pipeline including an error-accumulate portion;
Fig. 9 is a functional block diagram depicting a shadow pipeline including an error-accumulate portion and a analog to digital conversion portion;
Fig. 10 is a functional block diagram depicting a pipeline analog to digital converter employing two shadow pipelines;
Fig. 11 is a schematic diagram of a switched capacitor circuit suitable for use in the present invention; and
Fig. 12 is a functional block diagram depicting a pipeline analog to digital converter employing an analog to digital conversion shadow pipeline.

DETAILED DESCRIPTION OF THE INVENTION

Fig. 3 is a block diagram illustrating one embodiment of an apparatus for correcting the finite. gain error of one or more amplifiers within an amplifier chain of a pipeline ADC. The apparatus includes an error correcting portion 300 that includes four amplifier gain stages 302, 304, 306, and 308 contained within the amplifier chain within the main amplifier pipeline. At least one of the amplifier stages 302-308 provides a gain error signal, to a shadow pipeline 400. The gain error signals $V_{01}/A$, $V_{02}/A$, $V_{03}/A$, and $V_{04}/A$ are equal to the output of the particular stage divided by the open-loop gain A, of the operational amplifier used therein. The gain errors are sampled from the input of the summing node of the operational amplifier. The shadow pipeline 400 receives the at least one gain error signal and is configured and arranged to process this signal and to provide as an output an analog compensation signal. The analog compensation signal is combined with the output $V_{o4}$, which is the analog residue signal of stage 308. When combined together, the analog compensation signal will remove substantially all the finite gain error from the $V_{o4}$ signal that will be converted into a digital format by the downstream analog to digital converter stages in the main pipeline.
As noted above, the output of an amplifier stage is given by:

$$V_{Out} \approx V_{in} * G\left(1 - \frac{G}{A}\right) \approx V_{in} * G - V_{in} * \frac{G^2}{A}. \qquad (2)$$

Where the term G(1-G/A) is equal to the gain of the amplifier stage. As such, the output signal of the amplifier includes two components. The first component is an ideal output signal $V_{in}*G$ and the second component is an error signal $-V_{in}*G^2/A$. Where G is equal to the nominal gain of the amplifier stage, A, is equal to the open loop gain of the op-amp used internally in the amplifier stage, and $V_{in}$ is equal to the input signal to the amplifier stage. Therefore, each subsequent stage amplifies both the ideal output signal and the error signal of the preceding stage while also providing an additional finite gain error as well. Thus, the output for any amplifier stage within the main pipeline of the analog to digital converter can be approximated as a series expansion in terms of the open loop gain A:

$$V_{Out} = V_{In} * (G - \frac{G^2}{A})^N = V_{In} * (G^N - N * \frac{G^{N+1}}{A}) = V_{In} * G^N (1 - \frac{N*G}{A}) \qquad (3)$$

Where all terms having an open-loop gain value of $A^2$ or higher in the denominator are considered negligible so that the series expansion has been truncated after two terms. In equation (3) N is equal to the number amplifier stages within the error correcting portion 300 of the pipelined ADC and G is equal to the gain of each of the amplifiers contained within each stage. Although G is considered constant in equation (3), G may vary from stage to stage. In the event that G varies from stage to stage, the equation (3) can be modified to:

$$V_{Out} = V_{In} * G_1 * G_2 * G_3 * G_4 * (1 - \frac{(G_1 + G_2 + G_3 + G_4)}{A}) . \qquad (3A)$$

Where the terms $G_1$, $G_2$, $G_3$, and $G_4$ are equal to the amplifier gains for the four amplifier stages within the error correcting portion 300 of the pipeline ADC. Thus, the error due to the finite gain of the op-amps used within the amplifiers contained within the pipeline ADC is given by the second term of either equation (3) or (3A).

In the illustrated embodiments that follow, four (4) stages of a pipelined ADC are used as the error correcting portion 300 of the pipeline ADC. It should be understood that four (4) stages are provided for exemplary purposes only, and that any number of amplifier stages may be included in the error correcting portion of the pipeline ADC architecture. Additionally, only the single error term in equations (3) and (3A) is used in the equations that follow. It should be appreciated that a single error term is used for exemplary purposes only and that any number of error terms in the series expansion shown in equations (3) and (3A) may be used, with increasingly accurate results.

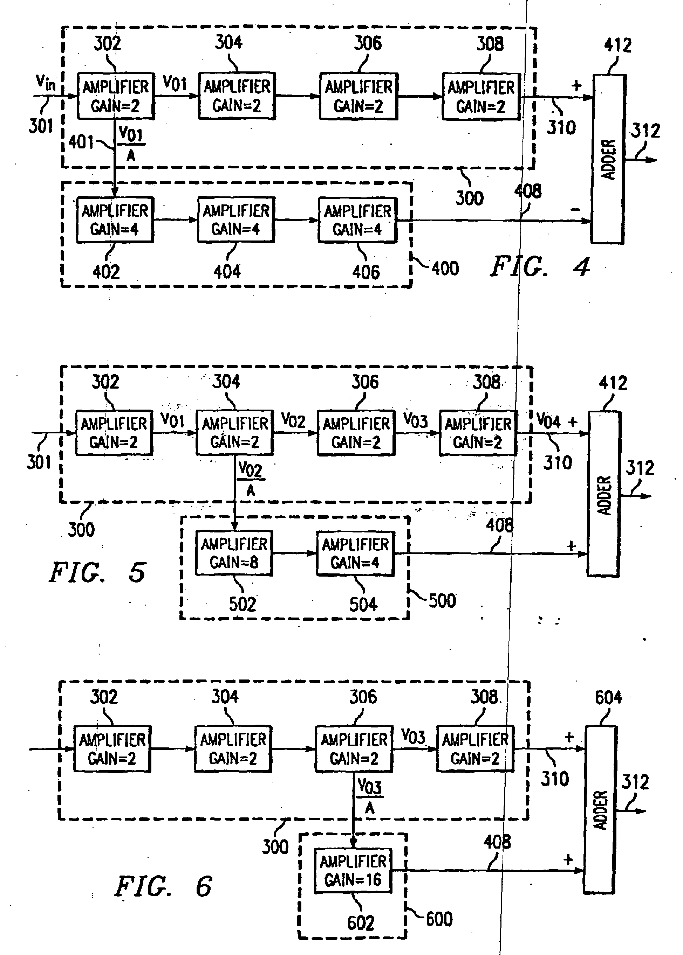

Figs. 4-7 illustrate embodiments of the present invention that includes a shadow pipeline. The shadow pipeline processes an input error signal provided by one of the amplifier stages in the error correcting portion of the main pipeline amplifier stages. The input error signal is processed by the shadow pipeline to provide a compensation signal 408. The analog compensation signal 408 is combined with the analog residue output signal of the error correcting portion 300 of the main pipeline to compensate for the finite open loop gain of the op-amps used within the amplifier chain of the main pipeline. The processed input gain error signal provided by the shadow pipeline in each figure *is* arithmetically combined with the signal output provided by the error correcting portion of the main pipeline to provide an output signal 312. In the illustrated embodiments, the processed input error signal is added to the output signal 312 provided by the error correcting portion 300 of the main pipeline since the error term as shown in equations (2), (3), and (3A) is negative. The compensated output signal 312 is provided as an output from the error correcting portion 300 of the main pipeline.

In the embodiment depicted in Fig. 4, the first stage 302 in the error correcting portion 300 of the main pipeline provides a gain error signal $V_{01}/A$ on line 401 to be processed by the shadow pipeline 400. This error signal is multiplied by a gain K that represents the gain of the shadow pipeline 400. To determine the value of the gain K that will substantially remove the finite gain error from the analog residue signal, the error signal is multiplied by K and set equal to the error term in equation (3) or (3A) and solved for the gain K. As noted above, the output on line 310 of the error correcting portion 300 of the main pipeline can be approximated by a truncated series expansion, and assuming each stage in the error correcting portion 300 of the main pipeline has a constant gain G yields:

$$\frac{V_{In} * G * K}{A} = \frac{V_{In} * N * G^{N+1}}{A} \Rightarrow K = G^N * N \qquad (4) .$$

Where, N is equal to the number of stages in the error correcting potion 300 of the main pipeline, and G is the constant gain of each amplifier stage in each of the error correcting stages. Therefore, as illustrated in Fig. 4, the value of K, i.e., the gain of the shadow pipeline will be 64, where G=2, and N=4.

In general, for a gain error signal provided by the $j^{th}$ amplifier stage in the error correcting portion 300 having N stages, and in which each stage has a gain of G, the value of the gain K of the shadow pipeline will be:

$$K = G^{N+1-j} * N \qquad (5)$$

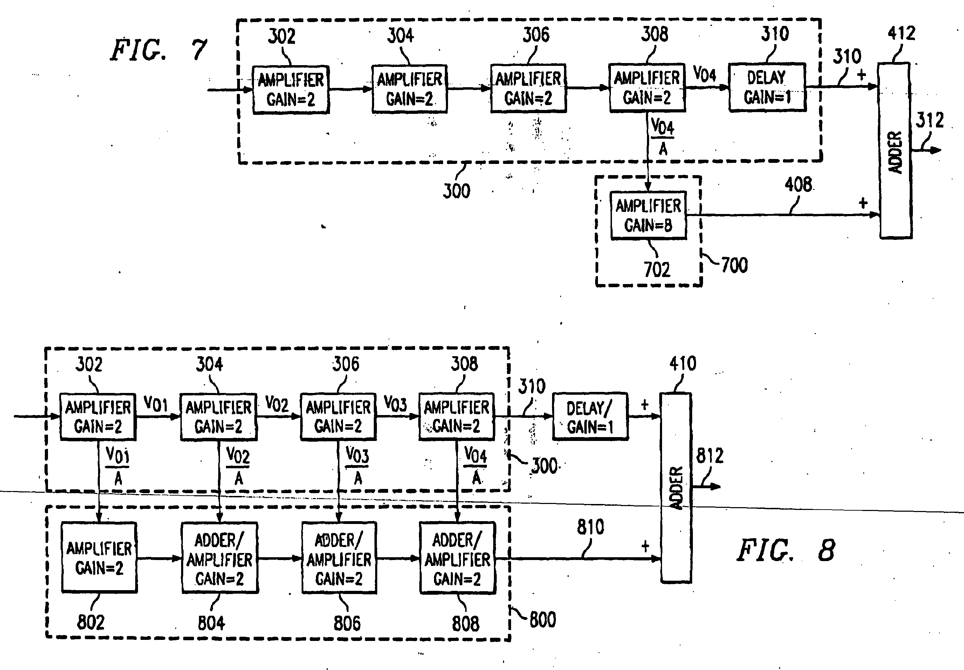

Therefore, as illustrated in Fig. 5, for a gain error signal, $V_{02}/A$, taken from the second stage 306, the total gain K of the shadow pipeline will be $G^{4+1-2}*4=32$. As illustrated in Fig. 6 for a gain error signal, $V_{03}/A$, taken from the third stage 308, the total gain K of the shadow pipeline will be $G^{4+1-3}*4=16$. As illustrated in Fig. 7, for a gain error signal, $V_{04}/A$, taken from the fourth stage 310, the total gain K of the shadow pipeline will be $G^{4+1-4}*4=8$. Fig. 7 further includes a delay stage having a gain 1 that may be necessary to ensure that the proper signals are present in the adder 412.

Although only four (4) error correcting stages are used in the illustrative embodiments, any number of error correcting stages may be used. In general, the error contribution by each stage decreases from the most significant bit stage to the least significant bit stage. The selection of the number of error correcting stages to be used within the main pipeline is a function of the accuracy required by the user. Greater accuracy in the final digital output will require more error correcting stages to be used.

In each embodiment depicted in Figs. 4-7 the shadow pipeline can be any arbitrary number of stages desired by the designer such that the overall gain of the shadow pipeline equals the value K determined in equations (4) or (5). The considerations for the number of amplifier stages in the shadow pipeline may include the area available on the ADC chip available for the amplifier modules, and the size and electrical characteristics of the operational amplifiers and the components used therewith to form the amplifier modules that can be used in the available chip area.

In some circumstances the error correcting stages in the main pipeline of the ADC may have different amplifier gains. For instance, some stages in the pipelined ADC may provide 1 bit of output, some stages may provide 1.5 bits of output, and some stages may provide 2 bits of output. In this case the gain of each stage in the pipelined ADC in equations (4) and (5) then the various gains would be multiplied together to calculate the overall gain of the pipelined amplifier stages as shown below:

$$K = \prod_{n=j+1}^{N} G_n * \left( \sum_{i=1}^{N} G_i \right) \qquad (5A) .$$

Where the term j is equal to the position of the error correcting stage within the error correcting portion 300 of the main pipeline ADC, and N is equal to the number of stages within the error correcting portion.

Fig. 8 depicts another embodiment of a shadow pipeline 800 in which each stage in the error correcting portion 300 of the main pipeline provides a gain error signal as described above. The shadow pipeline 800 accumulates and combines these errors into an analog compensation signal output on line 810. The compensation signal is combined with the output signal on line 310 from the last stage 308 in the error correcting portion 300 to remove the finite gain errors from the output.

In the embodiment illustrated in Fig. 8 the shadow pipeline 800 includes four (4) error accumulation and processing stages 802, 804, 806, and 808. Each of the error accumulation and processing stages receives a gain error signal from a corresponding stage in the error correcting portion 300 of the main pipeline. Thus, stage 302 provides a gain error signal equal to $V_{01}/A$ to stage 802. Stage 304 provides a gain error signal equal to $V_{02}/A$ to stage 804. Stage 306 provides an analog gain error signal equal to $V_{03}/A$ to stage 806, and stage 308 provides an analog gain error signal equal to $V_{04}/A$ to stage 808. Each of the error accumulation and processing stages 802-808 add the received gain error signal with a processed signal from a preceding stage, if any, and multiply this sum by a gain factor G to provide an output signal. Thus, if each stage of the pipelined stages has a gain of $G_i$, and each of the stages of the shadow pipeline has a gain of K, then equating the like terms to solve for K in the error yields:

$$\frac{V_h}{A} * (G*K^4 + G^2*K^3 + G^3*K^2 + G^4*K) = G^{N+1} * N * \frac{V_h}{A} \qquad (6)$$

As depicted in Fig. 8, one solution for equation (6) is when G=2 and K=2. In general, the gain K for any shadow pipeline stage is equal to the gain G of the corresponding amplifier stage that provides the gain error signal thereto. However, K may be varied for each stage in the shadow pipelined gain stages so long as the generalized version of equation (6) given below is satisfied:

$$\frac{V_{in}}{A} \cdot \sum_{j=1}^{N} (\prod_{k=1}^{j} G_k \cdot \prod_{i=j}^{N} K_i) = \frac{V_{in}}{A} \cdot \prod_{i=1}^{N} G_i \cdot \sum_{j=1}^{N} G_j$$

$$(7)$$

Where the term $K_i$ is equal to the value of the gain of the shadow pipeline stage i, and the term $G_j$ is equal to the gain of each of the pipelined gain stage j.

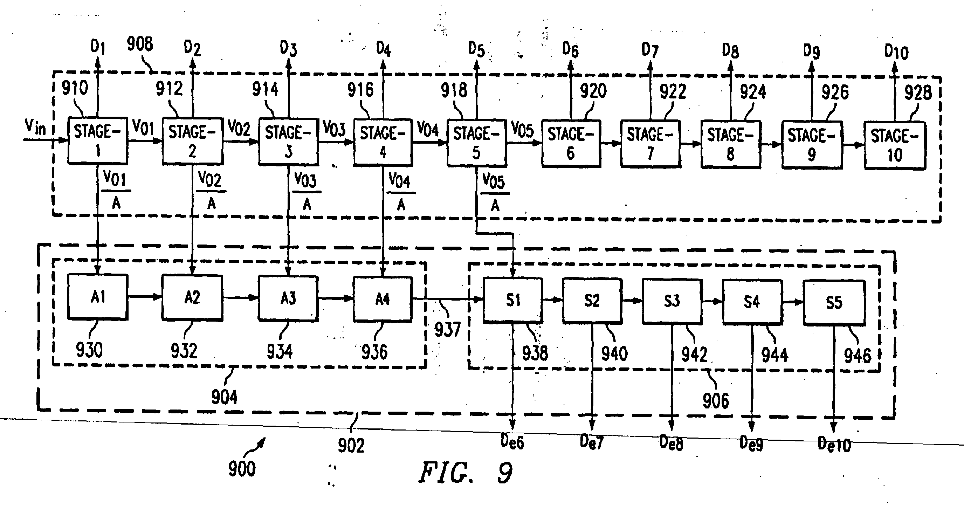

Fig. 9 depicts another embodiment of a shadow pipeline 902 that includes one or more error accumulation and processing stages. In this embodiment, the compensation signal provided by the error accumulation and processing stages 904 is converted into a digital format by an analog to digital converter stage 906. The digital compensation signal is then arithmetically combined with the digital butput bits from pre-selected stages in the main pipeline, to remove the finite gain errors from the digital output.

In the illustrated embodiment in Fig. 9, the main pipeline 908 includes ten (10) ADC stages, 910-928, forming a 10-bit-pipelined ADC, wherein each stage provides as a digital output one or more digital bits Di, where i is the position of the respective ADC stage. The shadow pipeline 902 is divided into two parts. The first part is an error-accumulate stage 904 that includes four stages 920, 922, 924, and 926 of the shadow pipeline 902. The error-accumulation stage 904 provides as an output an analog compensation signal on line 937. The second part of the shadow pipeline 902 is an analog to digital output stage 906 that receives the analog compensation signal and converts it into a one or more digital error correction bits.

In the illustrated embodiment, the error-accumulate stage 904 receives error signals from the first four Stages 910-916 of the main pipeline 908. Only the first four stages are used since the errors produced by these stages provide the largest component of the total error. Each of the four stages 930-936 in the error-accumulate stage 904 receives a gain error signal, $V_{01}/A$, $V_{02}/A$, $V_{03}/A$, and $V_{04}/A$ respectively from stages 910-916 respectively in the main pipeline 908.

The first stage 930 in the error-accumulate stage 904 receives the first gain error signal $V_{01}/A$. The first stage 930 multiplies the received gain error $V_{01}/A$ by a constant gain factor $K_1$. The gain factor $K_1$ is equal to the gain of the amplifier used in the corresponding ADC stage 910. Each subsequent stage in the error-accumulation stage 904 adds the output of the preceding stage to a gain error signal received from the corresponding amplifier stage in the main pipeline 908. This sum is multiplied by a constant gain factor $K_1$ that is equal to the gain G of the amplifier used in the corresponding ADC stage in the main pipeline 908. Thus, stage 932 receives the output of stage 930 and the gain error signal $V_{02}/A$. These two signals are added together and the sum is multiplied by a constant gain factor K that is equal to the gain of the amplifier used in the stage 912 in the main pipeline 908. Stage 934 receives the output of stage 932 and the gain error signal $V_{03}/A$ from stage 914 and processes these signals as described above. The constant gain factor used in multiplying the sum of the two signals is equal to the gain of the stage 914. Stage 936 receives the output of stage 934 and the gain error signal $V_{04}/A$ from stage 916 and processes these signals as described above. The constant gain factor used in multiplying the sum of the two signals is equal to the gain of the stage 916.

The analog compensation output signal from the last stage 936 in the error accumulation stage 904 is provided to the analog to digital converter stage 906 that includes at least a one bit analog to digital converter. In the illustrated embodiment, the first analog to digital converter stage 928 receives the output from the last stage, 926, of the error accumulate stage 904 and a gain error signal $V_{05}/A$ from amplifier stage 918 in the main pipeline 908. These signals are added together and converted into a digital format by stages 938, 940, 942, 944, and 946. Each of the analog to digital converter stages 938-946 in the shadow pipeline 902 provide one or more digital error correcting output bits. The digital error correcting output bits from stages 938, 940, 942, 944, and 946 are combined by adding, with the digital output of the corresponding stages 920, 922, 924, 926, and 928 respectively in the main pipeline 908. Similarly, the digital error correcting bits provided by the analog-to-digital converter stages 938-940-942, 944, and 946 could be a 5 bit FLASH analog-to-digital converter, a subranging ADC, a two step or multi-step ADC, a sigma-delta ADC, a cyclic and algorithmic ADC, a single or dual slope ABC, or a successive approximation ADC, or any other form of analog-to-digital converter with suitable output resolution and speed.

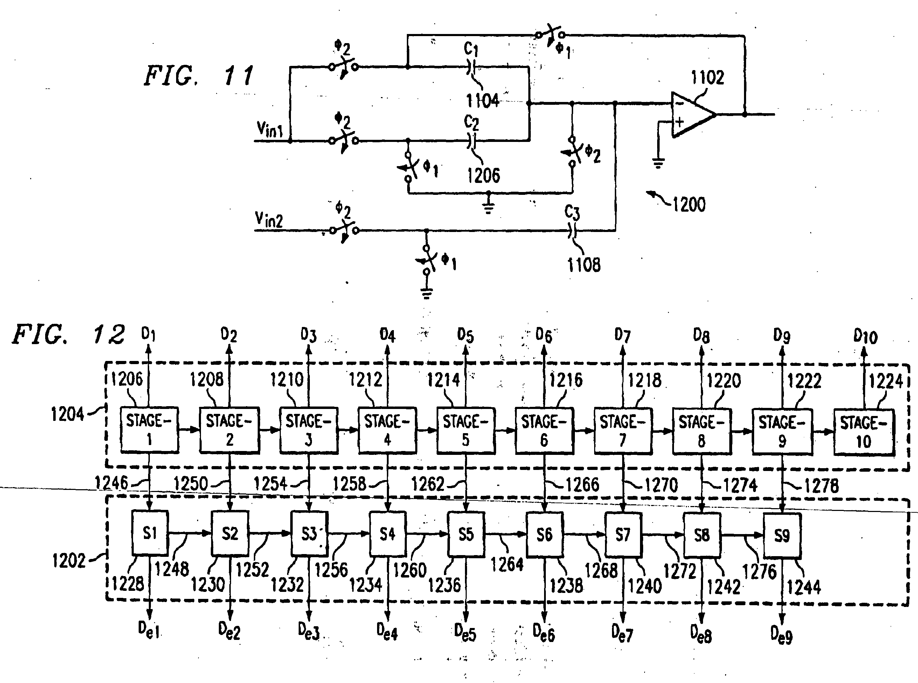

Fig. 12 depicts an alternative embodiment in which each stage in the shadow pipeline 1202 is an error-accumulating-analog-to-digital-converter stage. The first stage in the shadow pipeline 1228 receives the output error signal 1246 from the first stage 1206 of the main pipeline 1204. The first shadow stage 1228 converts the output error signal into a M bit digital word and provides a residue signal 1248 to the second stage 1230 of the shadow pipeline 1202. The second stage 1230 receives the residue signal 1248 from the first stage 1228 and an output error signal 1250 from the second stage 1208 of the main pipeline 1204. The second stage 1230 accumulates the two error signals together and converts the accumulated errors into a M-bit digital word, and provides a residue signal 1252 to the third stage 1232 of the shadow pipeline 1202. Each stage subsequent stage 1232-1244 receives the residue signal, 1252-1276 respectively, from the preceding stage and accumulates this residue error signal with the output error signal, 1254-1278 respectively, of the corresponding analog to digital stage in the main pipeline 1204. The output error bits De1-De9 provided by the shadow pipeline 1202 are added to the output bits D1-D10 provided by the main pipeline 1204, respectively, to remove the output gain error term from the digital output. As described above, the output error bits De1-De10 do not have to be provided by a pipelined analog-to-digital converter. The output error bits De1-De10 could be provided by a 10 bit FLASH analog-to-digital converter, a subranging ADC, a two step or multi-step ADC, a sigma-delta ABC, a cyclic and algorithmic ADC, a single or dual slope ADC, or a successive approximation ADC, or any other form of analog-to-digital converter with suitable output resolution and speed.

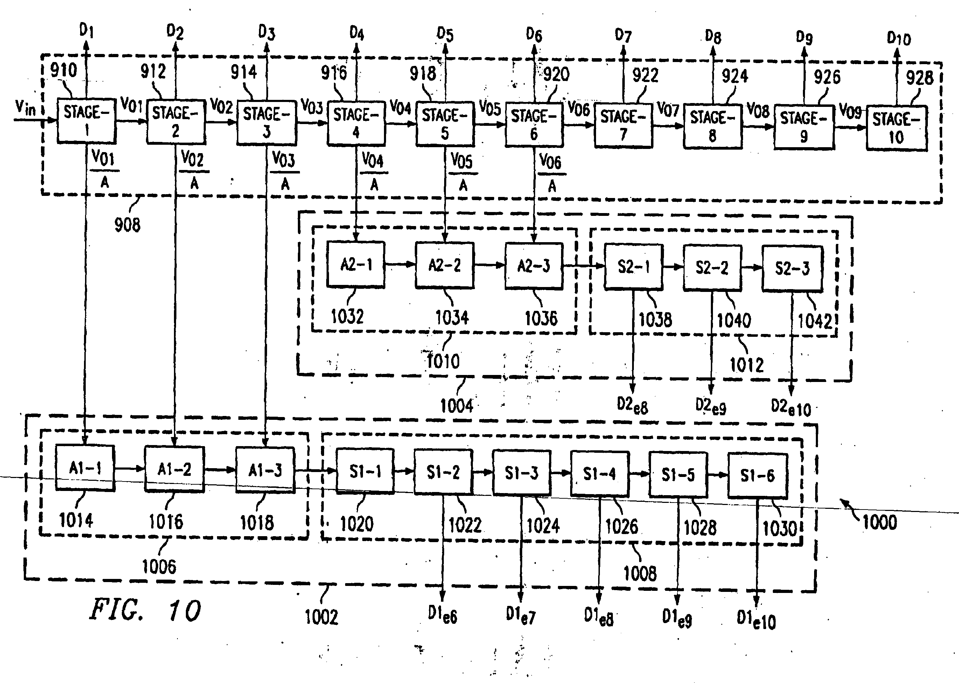

In some circumstances, the gain error signals may be large and an overflow may occur in the error accumulate stage 1004. This may be caused, for example, by op-amps having open loop gains on the order of 50-100 instead of 500-1000. In this case, as depicted in Fig. 10, the shadow pipeline is divided into at least two parts: a first shadow pipeline 1002 and a second shadow pipeline 1004. The first shadow pipeline 1002 includes an error-accumulation stage 1006 that receives a first set of gain error signals $V_{01}/A$, $V_{02}/A$, and $V_{03}/A$ from the first three stages 910-914 of the main pipeline 908. This first set of gain error signals is processed by the error-accumulate stage 1006 as described above with respect to Fig. 9. That is the first stage 1014 in the error-accumulate stage 1006 receives the first gain error signal $V_{01}/A$. The first stage 1014 multiplies the received gain error $V_{01}/A$ by a constant gain factor $K_1$. The gain factor K is equal to the gain of the amplifier used in the corresponding ADC stage 910. Each subsequent stage in the error-accumulation stage 1006 adds the output of the preceding stage to a gain error signal received from the corresponding amplifier stage in the main pipeline 908. This sum is multiplied by a constant gain factor K that is equal to the gain G of the amplifier used in the corresponding ADC stage in the main pipeline 908, Thus, stage 1016 receives the output of stage 1014 and the gain error signal $V_{02}/A$. These two signals are added together and the sum is multiplied by a constant gain factor that is equal to the gain of the amplifier used in the stage 912 in the main pipeline 908. Stage 1018 receives the output of stage 1016 and the gain error signal $V_{03}/A$ from stage 914 and processes these signals as described above. Stage 1018 provides a first analog compensation signal to a first digital error output stage 1008 where the first analog compensation signal is converted into one or more first digital error correcting bits. The first digital error output stage 1008 can be a pipelined analog-to-digital converter, or a FLASH analog-to-digital converter, a subranging ADC, a two step or multi-step ADC, a sigma-delta ADC, a cyclic and algorithmic ADC, a single or dual slope ADC, or a successive approximation ADC, or any other form of analog-to-digital converter with suitable output resolution and speed.

The second shadow pipeline 1004 includes an error-accumulate stage 1006 that receives a second set of gain error signals $V_{04}/A$, $V_{05}/A$, and $V_{06}/A$ from a second group of error correcting stages 916-920 respectively in the main pipeline 908. This second set of gain error signals is processed by the error-accumulate stage 1006 as described above. That is the second stage 1004 in the error-accumulate stage 1004 receives the first gain error signal $V_{04}/A$. The first stage 1032 multiplies the received gain error $V_{04}/A$ by a constant gain factor $K_1$. The gain factor K is equal to the gain of the amplifier used in the corresponding ADC stage 916. Each subsequent stage in the error-accumulation stage 1004 adds the output of the preceding stage to a gain error signal received from the corresponding amplifier stage in the main pipeline 908. This sum is multiplied by a constant gain factor K that is equal to the gain G of the amplifier used in the corresponding ADC stage in the main pipeline 908. Thus, stage 1034 receives the output of stage 1032 and the gain error signal $V_{05}/A$. These two signals are added together and the sum is multiplied by a constant gain factor that is equal to the gain of the amplifier used in the stage 918 in the main pipeline 908. Stage 1036 receives the output of stage 1034 and the gain error signal $V_{06}/A$ from stage 920 and processes these signals as described above. Stage 1036 provides a second analog compensation signal to a second digital error output stage 1012 where the second analog compensation signal is converted into one or more second digital error correcting bits. Each of the corresponding digital error correcting bits from the first and second digital error output stages 1012 and 1008 respectively are added to the corresponding digital output bit provided by the main pipeline 1002 in order to substantially remove the finite gain error in the digital output. The second digital error output stage 1012 can be a pipelined analog-to-digital converter, or a FLASH analog-to-digital converter, a subranging ADC, a two step or multi-step ADC, a sigma-delta ADC, a cyclic and algorithmic ADC, a single or dual slope ADC, or a successive approximation ADC, or any other form of analog-to-digital converter with suitable output resolution and speed.

Fig. 11 depicts a switched capacitor amplifier that is suitable for use within the shadow pipeline in the embodiments described herein. The output is given by:

$$V_{out} = \frac{V_1 * \left(\frac{C1+C2}{C2}\right)}{1+\left(\frac{C1+C2+C3}{C2*A}\right)} + \frac{V2 * \frac{C3}{C2}}{1+\left(\frac{C1+C2+C3}{C2*A}\right)} \quad (8)$$

Where C1, C2, and C3 are the values of the capacitors 906, 904, and 908 respectively and A is the open loop gain of the op-amp 902. By eliminating C1 and C3 the above circuit a delay circuit having a gain of one (1) is provided. Eliminating C1 results in an adder circuit having no gain is provided. By adjusting the ratios of the capacitors arbitrary gain factors for the inputs may be provided.

Those of ordinary skill in the art should further appreciate that variations to and modification of the above-described methods and apparatus for correcting the finite gain errors in a pipeline ADC may be made without departing from the inventive concepts disclosed herein.

## Claims

1. An apparatus for compensating amplifier gain error in a pipelined analog to digital converter having a main pipeline (300; 908; 1204)including a plurality of analog to digital converter stages, each stage (302-308; 910-928; 1206-1224) having a amplifier having a corresponding gain, the apparatus comprising:

   a plurality of error correcting stages (302-308; 910-928; 1206-1224) including a predetermined number of adjacent analog to digital converter stages in the main pipeline (300; 908; 1204), the plurality of error correcting stages providing a residue output signal (310);
   at least one shadow pipeline (400; 500; 600; 700; 800; 902; 1002, 1004; 1202) having at least one shadow stage(402-406; 502-504; 602; 702; 802-808; 930-936; 1014-1018, 1032-1036; 1228-1244), the shadow pipeline receiving a gain error signal from at least one of the plurality of error correcting stages (302, 304, 306, 308), the shadow pipeline configured and arranged to provide a compensation signal (408; 810); and
   a combination module (412) configured and arranged to combine the compensation signal (408; 810)and the residue output signal (310)to provide an error compensated signal (312; 812);
   **characterised in**
   the compensation signal (408; 810) being equal to the gain error signal received from the at least one of the plurality of error correcting stages multiplied by a gain factor, wherein the gain factor is substantially equal to the product of the gains corresponding to each of the subsequent error correcting stages, multiplied by the sum of the gains of the stages in the plurality of error correcting stages, whereby the subsequent error stages are the stages following the stage which outputs the gain error signal.

2. The apparatus of claim 1, wherein the gain corresponding to the amplifier in each stage in the main pipeline (300; 908; 1204) is two and the number of stages in the plurality of error correcting stages is N, and wherein the gain of the at least one shadow gain stage is $N*2^N$.

3. The apparatus of claim 2, wherein the first stage (302; 910; 1206) of the plurality of error correcting stages is the first analog to digital converter stage in the main pipeline (300; 908; 1204).

4. The apparatus of claim 1, wherein the at least one of the plurality of error correcting stages is the first error correcting stage.

5. The apparatus of claim 1, wherein the combination module (412) is an addition module configured and arranged to add the compensation signal (408; 810) and the residue output signal (310).

6. The apparatus of claim 1, wherein the at least one shadow stage (402-406; 502-504; 602; 702; 802-808; 930-936; 1014-1018, 1032-1036; 1228-1244)includes an analog to digital converter, and wherein the compensation signal (408; 810) is at least one digital error bit.

7. The apparatus of claim 1, wherein the plurality of error correcting stages includes a first error correcting stage (302) and a plurality of subsequent error correcting stages (304-308)and
the shadow pipeline (800) including a plurality of shadow stages (802-808), wherein a first shadow stage (802) receives a first gain error signal from the first error correcting stage (302) of the plurality of error correcting stages, the first shadow stage (802) being configured and arranged to multiply the first gain error signal by a first gain constant and to provide a first shadow signal and each subsequent shadow pipeline stage (804-808) being arranged to receive a shadow signal from the preceding shadow pipeline stage (802-806) and a gain error signal from corresponding stage (304-308) of the plurality of error correcting stages and to add the shadow signal and the gain error signal together and multiply the sum by a gain factor and wherein the output of the plurality of shadow stages (802-808) is the compensation signal (810).

8. The apparatus of claim 7, wherein the gain of each of the plurality of shadow stages (802-808) is substantially equal to the gain of the corresponding amplifier contained within the analog to digital converter stage in the plurality of error correcting stages (302-308) that provides the gain error signal thereto.

9. The apparatus of claim 7, wherein the gain corresponding to the amplifier in each stage (302-308) in the main pipeline (300) is two and the gain of each corresponding stage (802-808) in the shadow pipeline (800) is two.

10. The apparatus of claim 1, wherein the shadow pipeline (900) includes a plurality of shadow stages (930-946) and further comprises:

an error accumulate portion (904) arranged to receive a plurality of gain error signals from a subset (910-916) of the plurality of analog to digital converter stages (910-928) contained within the main pipeline (908), to accumulate and process the received plurality of gain error signals and to provide as an output an analog compensation signal (937); and
a shadow analog to digital compensation output portion (906) arranged to receive the analog compensation signal (937) and to provide an M-bit output digital signal ($D_{e6}$-$D_{e10}$) representative of the analog compensation error signal (937); and wherein the combination module comprises an adder stage arranged to add the M-bit output digital signal ($D_{e6}$-$D_{e10}$) with the least significant M bits (D1-D10) provided by the plurality of analog to digital converter stages (910-928) in the main pipeline.

11. The apparatus of claim 10, wherein the shadow analog to digital compensation output portion (906) of the shadow pipeline (900) includes a pipeline analog to digital converter.

12. The apparatus of claim 10, wherein the shadow analog to digital compensation output portion (106) of the shadow pipeline (900) includes one from the group of a FLASH analog-to-digital converter, a subranging analog to digital converter, a two step or multi-step analog to digital converter, a sigma-delta analog to digital converter, a cyclic and algorithmic analog to digital converter, a single or dual slope analog to digital converter, or a successive approximation analog to digital converter, or any other form of analog-to-digital converter with suitable output resolution and speed.

13. The apparatus of claim 1, wherein the at least one shadow pipeline comprises at least first (1002) and second (1004) shadow pipelines, each including a plurality of shadow pipeline stages (1014-1030), 1032-1042) and each of the first and second shadow pipelines comprising:

an error accumulate portion (1006, 1010), wherein the error accumulate portion (106) of the first shadow pipeline (1002) is arranged to receive a plurality of gain error signals from a first subset (910-914) of the plurality of analog to digital converter stages (910-928) contained within the main pipeline (908), to accumulate and process the received plurality of gain error signals and to provide as an output a first analog compensation signal and wherein the error accumulate portion (1010) of the second shadow pipeline (1004) is arranged to receive a plurality of gain error signals from a second subset (916-920) of the plurality of analog to digital converter stages (910-928) contained within the main pipeline (908), to accumulate and process the received plurality of gain error signals and to provide as an output a second analog compensation signal; and
an analog to digital compensation output portion (1008, 1012), wherein the analog to digital output portion (1008) of the first shadow pipeline (1002) is arranged to receive the first analog compensation signal and to provide an M-bit output digital signal ($D1_{e6}$-$D1_{e10}$) representative of the first analog compensation signal and wherein the analog to digital output portion (1012) of the second shadow processor (1004) is arranged to receive the second analog compensation signal and to provide an L-bit output digital signal ($D2_{e8}$-$D2_{e10}$) representative of the second analog compensation signal; and

wherein the combination module comprises an adder stage configured and arranged to add the M-bit output digital signal $(D1_{e6}\text{-}D1_{e10})$ with the least significant M bits $(D_1\text{-}D_{10})$ provided by the plurality of analog to digital converter stages (910-928) in the main pipeline (908) and to add the L-bit output digital signal $(D2_{e8}\text{-}D2_{e10})$ with the least significant L bits $(D_1\text{-}D_{10})$ provided by the plurality of analog to digital converter stages (910-928) in the main pipeline (908).

14. The apparatus in claim 13, wherein the analog to digital compensation output portion (1008) of the first shadow pipeline (1002) includes a pipelined analog to digital converter.

15. The apparatus in claim 14, wherein the analog to digital compensation output portion (1008) of the first shadow pipeline (1002) includes one from the group of a FLASH analog-to-digital converter, a subranging analog to digital converter, a two step or multi-step analog to digital converter, a sigma-delta analog to digital converter, a cyclic and algorithmic analog to digital converter, a single or dual slope analog to digital converter, or a successive approximation analog to digital converter, or any other form of analog-to-digital converter with suitable output resolution and speed.

16. The apparatus in claim 13, wherein the analog to digital compensation output portion (1012) of the second shadow pipeline (1004) includes a pipelined analog to digital converter.

17. The apparatus in claim 13 wherein the analog to digital compensation output portion (1012) of the second shadow processor (1004) includes one from the group of a FLASH analog-to-digital converter, a subranging analog to digital converter, a two step or multi-step analog to digital converter, a sigma-delta analog to digital converter, a cyclic and algorithmic analog to digital converter, a single or dual slope analog to digital converter, or a successive approximation analog to digital converter, or any other form of analog-to-digital converter with suitable output resolution and speed.

**Patentansprüche**

1. Vorrichtung zum Kompensieren eines Verstärker-Verstärkungsfehlers in einem Pipeline-Analog/Digital-Umsetzer mit einer Haupt-Pipeline (300; 908; 1204), die mehrere Analog/Digital-Umsetzerstufen enthält, wobei jede Stufe (302-308; 910-928; 1206-1224) einen Verstärker mit einer entsprechenden Verstärkung besitzt, wobei die Vorrichtung umfasst:

mehrere Fehlerkorrekturstufen (302-308; 910-928; 1206-1224), die eine vorgegebene Anzahl benachbarter Analog/Digital-Umsetzerstufen in der Haupt-Pipeline (300; 908; 1204) enthalten, wobei die mehreren Fehlerkorrekturstufen ein Restausgangssignal (310) bereitstellen;
wenigstens eine Schatten-Pipeline (400; 500; 600; 700; 800; 902; 1002, 1004; 1202), die wenigstens eine Schattenstufe (402-406; 502-504; 602; 702; 802-808; 930-936; 1014; 1018, 1032-1036; 1228-1244) besitzt, wobei die Schatten-Pipeline ein Verstärkungsfehlersignal von wenigstens einer der mehreren Fehlerkorrekturstufen (302-308; 910-928; 1206-1224) empfängt, wobei die Schatten-Pipeline so konfiguriert und ausgelegt ist, dass sie ein Kompensationssignal (408; 810) bereitstellt; und
ein Kombinationsmodul (412), das so konfiguriert und ausgelegt ist, dass es das Kompensationssignal (408; 810) und das Restausgangssignal (310) kombiniert, um ein fehlerkompensiertes Signal (312; 812) bereitzustellen;
**dadurch gekennzeichnet, dass**
das Kompensationssignal (408; 810) gleich dem mit einem Verstärkungsfaktor multiplizierten Verstärkungsfehlersignal, das von der wenigstens einen der mehreren Fehlerkorrekturstufen empfangen wird, ist, wobei der Verstärkungsfaktor im Wesentlichen gleich dem Produkt der Verstärkungen, die jeder der nachfolgenden Fehlerkorrekturstufen entsprechen, multipliziert mit der Summe der Verstärkungen der Stufen in den mehreren Fehlerkorrekturstufen, ist, wobei die nachfolgenden Fehlerstufen jene Stufen sind, die der Stufe folgen, die das Verstärkungsfehlersignal ausgibt.

2. Vorrichtung nach Anspruch 1, wobei die Verstärkung, die dem Verstärker in jeder Stufe in der Haupt-Pipeline (300; 908; 1204) entspricht, gleich zwei ist und die Anzahl der Stufen in den mehreren Fehlerkorrekturen N ist, wobei die Verstärkung der wenigstens einen Schatten-Verstärkungsstufe gleich $N \times 2^N$ ist.

3. Vorrichtung nach Anspruch 2, wobei die erste Stufe (302; 910; 1206) der mehreren Fehlerkorrekturstufen die erste Analog/Digital-Umsetzerstufe in der Haupt-Pipeline (300; 908; 1204) ist.

4. Vorrichtung nach Anspruch 1, wobei die wenigstens eine der mehreren Fehlerkorrekturstufen die erste Fehlerkorrekturstufe ist.

5. Vorrichtung nach Anspruch 1, wobei das Kombinationsmodul (410) ein Additionsmodul ist, das so konfiguriert und ausgelegt ist, dass es das Kompensationssignal (408; 810) und das Restausgangssignal (310) addiert.

6. Vorrichtung nach Anspruch 1, wobei die wenigstens eine Schattenstufe (402-406; 502-504; 602; 702; 802-808; 930-936; 1014; 1018, 1032-1036; 1228-1244) einen Analog/Digital-Umsetzer enthält und wobei das Kompensationssignal (408; 810) wenigstens ein digitales Fehlerbit ist.

7. Vorrichtung nach Anspruch 1, wobei die mehreren Fehlerkorrekturstufen eine erste Fehlerkorrekturstufe (302) und mehrere nachfolgende Fehlerkorrekturstufen (304-308) enthalten und
die Schatten-Pipeline (800) mehrere Schattenstufen (802-808) enthält, wobei die erste Schattenstufe (802) ein erstes Verstärkungsfehlersignal von der ersten Fehlerkorrekturstufe (302) der mehreren Fehlerkorrekturstufen empfängt, wobei die erste Schattenstufe (802) so konfiguriert und ausgelegt ist, dass sie das erste Verstärkungsfehlersignal mit einer ersten Verstärkungskonstante multipliziert und ein erstes Schattensignal bereitstellt und wobei jede nachfolgende Schatten-Pipelinestufe (804-808) so ausgelegt ist, dass sie ein Schattensignal von einer vorhergehenden Schatten-Pipelinestufe (802-806) und ein Verstärkungsfehlersignal von der entsprechenden Stufe (304-308) der mehreren Fehlerkorrekturstufen empfängt und das Schattensignal und das Verstärkungsfehlersignal addiert und die Summe mit einem Verstärkungsfaktor multipliziert, wobei der Ausgang der mehreren Schattenstufen (802-808) das Kompensationssignal (810) ist.

8. Vorrichtung nach Anspruch 7, wobei die Verstärkung jeder der mehreren Schattenstufen (802-808) im Wesentlichen gleich der Verstärkung des entsprechenden Verstärkers ist, der in der Analog/Digital-Umsetzerstufe in den mehreren Fehlerkorrekturstufen (302-308), die hierfür das Verstärkungsfehlersignal bereitstellt, enthalten ist.

9. Vorrichtung nach Anspruch 7, wobei die Verstärkung, die dem Verstärker in jeder Stufe (302-308) in der Haupt-Pipeline (300) entspricht, gleich zwei ist und die Verstärkung jeder entsprechenden Stufe (802-808) in der Schatten-Pipeline (800) gleich zwei ist.

10. Vorrichtung nach Anspruch 1, wobei die Schatten-Pipeline (900) mehrere Schattenstufen (930-946) enthält und ferner umfasst:

einen Fehlerakkumulationsabschnitt (904), der so ausgelegt ist, dass er mehrere Verstärkungsfehlersignale von einer Untermenge (910-916) der mehreren Analog/Digital-Umsetzerstufen (910-928), die in der Haupt-Pipeline (908) enthalten sind, empfängt, um die empfangenen mehreren Verstärkungsfehlersignale zu akkumulieren und zu verarbeiten und als eine Ausgabe ein analoges Kompensationssignal (937) bereitzustellen; und einen Schatten-Analog/Digital-Kompensationsausgangsabschnitt (906), der so ausgelegt ist, dass er das analoge Kompensationssignal (937) empfängt und ein digitales M-Bit-Ausgangssignal ($D_{e6}$-$D_{e10}$), das das analoge Kompensationsfehlersignal (937) repräsentiert, bereitstellt; und wobei das Kombinationsmodul eine Addiererstufe umfasst, die so ausgelegt ist, dass sie das digitale M-Bit-Ausgangssignal ($D_{e6}$-$D_{e10}$) und die niedrigstwertigen M Bits (D1-D10), die durch die mehreren Analog/Digital-Umsetzerstufen (910-928) in der Haupt-Pipeline bereitgestellt werden, addiert.

11. Vorrichtung nach Anspruch 10, wobei der Schatten-Analog/Digital-Kompensationsausgangsabschnitt (906) der Schatten-Pipeline (900) einen Pipeline-Analog/Digital-Umsetzer enthält.

12. Vorrichtung nach Anspruch 10, wobei der Schatten-Analog/Digital-Kompensationsausgangsabschnitt (106) der Schatten-Pipeline (900) einen Umsetzer aus der folgenden Gruppe enthält: FLASH-Analog/Digital-Umsetzer, Unterbereichs-Analog/Digital-Umsetzer, zweistufiger oder mehrstufiger Analog/Digital-Umsetzer, Sigma/Delta-Analog/Digital-Umsetzer, zyklischer und algorithmischer Analog/Digital-Umsetzer, Einzel- oder Doppelrampen-Analog/Digital-Umsetzer oder Analog/Digital-Umsetzer mit sukzessiver Approximation oder irgendeine andere Form eines Analog/Digital-Umsetzers mit geeigneter Ausgangsauflösung und Geschwindigkeit.

13. Vorrichtung nach Anspruch 1, wobei die wenigstens eine Schatten-Pipeline wenigstens eine erste (1002) und eine zweite (1004) Schattenpipeline umfasst, wovon jede mehrere Schatten-Pipelinestufen (1014-1030, 1032-1042) enthält und wobei jede der ersten und zweiten Schatten-Pipelines umfasst:

einen Fehlerakkumulationsabschnitt (1006, 1010), wobei der Fehlerakkumulationsabschnitt (106) der ersten Schatten-Pipeline (1002) so ausgelegt ist, dass er mehrere Verstärkungsfehlersignale von einer ersten Untermenge (910-914) der mehreren Analog/Digital-Umsetzerstufen (910-928), die in der Haupt-Pipeline (908) enthalten sind, empfängt, dass er die empfangenen mehreren Verstärkungsfehlersignale akkumuliert und verarbeitet und dass er als eine Ausgabe ein erstes analoges Kompensationssignal bereitstellt, wobei der Fehlerakkumulationsabschnitt (1010) der zweiten Schatten-Pipeline (1004) so ausgelegt ist, dass er mehrere Verstärkungsfehlersignale von einer zweiten Untermenge (916-920) der mehreren Analog/Digital-Umsetzerstufen (910-928), die in der Haupt-Pipeline (908) enthalten sind, empfängt, dass er die empfangenen mehreren Verstärkungsfehlersignale akkumuliert und verarbeitet und dass er als eine Ausgabe ein zweites analoges Kompensationssignal bereitstellt; und

einen Analog/Digital-Kompensationsausgangsabschnitt (1008, 1012), wobei der Analog/Digital-Ausgangsabschnitt (1008) der ersten Schatten-Pipeline (1002) so ausgelegt ist, dass er das erste analoge Kompensationssignal empfängt und ein digitales M-Bit-Ausgangssignal ($D1_{e6}$-$D1_{e10}$), das das erste analoge Kompensationssignal repräsentiert, bereitstellt, und wobei der Analog/Digital-Ausgangsabschnitt (1012) des zweiten Schattenprozessors (1004) so ausgelegt ist, dass er das zweite analoge Kompensationssignal empfängt und dass er ein digitales L-Bit-Ausgangssignal ($D2_{e8}$-$D2_{e10}$), das das zweite analoge Kompensationssignal repräsentiert, bereitstellt; und

wobei das Kombinationsmodul eine Addiererstufe umfasst, die konfiguriert und ausgelegt ist, um das digitale M-Bit-Ausgangssignal ($D1_{e6}$-$D1_{e10}$) und die niedrigstwertigen M Bits ($D_1$-$D_{10}$), die durch die mehreren Analog/Digital-Umsetzerstufen (910-928) in der Haupt-Pipeline (908) bereitgestellt werden, zu addieren und um das digitale L-Bit-Ausgangssignal ($D2_{e8}$-$D2_{e10}$) und die niedrigstwertigen L Bits ($D_1$-$D_{10}$), die durch die mehreren Analog/Digital-Umsetzerstufen (910-928) in der Haupt-Pipeline (908) bereitgestellt werden, zu addieren.

**14.** Vorrichtung nach Anspruch 13, wobei der Analog/Digital-Kompensationsausgangsabschnitt (1008) der ersten Schatten-Pipeline (1002) einen Pipeline-Analog/Digital-Umsetzer enthält.

**15.** Vorrichtung nach Anspruch 14, wobei der Analog/Digital-Kompensationsausgangsabschnitt (1008) der ersten Schatten-Pipeline (1002) einen Umsetzer aus der folgenden Gruppe enthält: FLASH-Analog/Digital-Umsetzer, Unterbereichs-Analog/Digital-Umsetzer, zweistufiger oder mehrstufiger Analog/Digital-Umsetzer, Sigma/Delta-Analog/Digital-Umsetzer, zyklischer und algorithmischer Analog/Digital-Umsetzer, Einzel- oder Doppelrampen-Analog/Digital-Umsetzer oder Analog/Digital-Umsetzer mit sukzessiver Approximation oder irgendeine andere Form eines Analog/Digital-Umsetzers mit geeigneter Ausgangsauflösung und Geschwindigkeit.

**16.** Vorrichtung nach Anspruch 13, wobei der Analog/Digital-Kompensationsausgangsabschnitt (1012) der zweiten Schatten-Pipeline (1004) einen Pipeline-Analog/Digital-Umsetzer enthält.

**17.** Vorrichtung nach Anspruch 13, wobei der Analog/Digital-Kompensationsausgangsabschnitt (1012) des zweiten Schattenprozessors (1004) einen Umsetzer aus der folgenden Gruppe enthält: FLASH-Analog/Digital-Umsetzer, Unterbereichs-Analog/Digital-Umsetzer, zweistufiger oder mehrstufiger Analog/Digital-Umsetzer, Sigma/Delta-Analog/Digital-Umsetzer, zyklischer und algorithmischer Analog/Digital-Umsetzer, Einzel- oder Doppelrampen-Analog/Digital-Umsetzer oder Analog/Digital-Umsetzer mit sukzessiver Approximation oder irgendeine andere Form eines Analog/Digital-Umsetzers mit geeigneter Ausgangsauflösung und Geschwindigkeit.

## Revendications

**1.** Appareil pour compenser une erreur de gain d'amplificateur dans un convertisseur analogique-numérique à pipeline comprenant un pipeline principal (300 ; 908 ; 1204) comportant plusieurs étages de convertisseur analogique-numérique chaque étage (302-308 ; 910-928 ; 1206-1224) ayant un amplificateur possédant un gain correspondant, lequel appareil comprend :

- plusieurs étages de correction d'erreur (302-308 ; 910-928 ; 1206-1224) comprenant un nombre prédéterminé d'étages de convertisseur analogique-numérique adjacents dans le pipeline principal (300 ; 908 ; 1204), la pluralité des étages de correction d'erreur fournissant un signal de sortie de résidu (310) ;
- au moins un pipeline fantôme (400 ; 500 ; 600 ; 700 ; 800 ; 902 ; 1002 ; 1004 ; 1202) comprenant au moins un étage fantôme (402-406 ; 502-504 ; 602 ; 702 ; 802-808 ; 930-936 ; 1014-1018 ; 1032-1036 ; 1228-1244), lequel pipeline fantôme reçoit un signal d'erreur de gain d'au moins de la pluralité des étages de correction d'erreur (302, 304, 306, 308), le pipeline fantôme étant configuré et disposé de manière à fournir un signal de compensation (408 ; 810) ; et

- un module de combinaison (412) configuré et disposé de manière à combiner le signal de compensation (408 ; 810) et le signal de sortie de résidu (310) afin de fournir un signal compensé en erreur (312 ; 812) ;

**caractérisé en ce que** le signal de compensation (408 ; 810) est égal au signal d'erreur de gain reçu de l'au moins un de la pluralité des étages de correction d'erreur multiplié par un facteur de gain, le facteur de gain étant essentiellement égal au produit des gains correspondant à chacun des étages de correction d'erreur suivants multiplié par la somme des gains des étages dans lesdits plusieurs étages de correction de gain, les étages d'erreur suivants étant les étages suivant l'étage qui émet le signal d'erreur de gain.

2. Appareil selon la revendication 1, dans lequel le gain correspondant à l'amplificateur dans chaque étage du pipeline principal (300 ; 908 ; 1204) est de deux, le nombre d'étages dans lesdits plusieurs étages de correction d'erreur est N, et le gain de l'au moins un étage de gain fantôme est $N*2^N$.

3. Appareil selon la revendication 2, dans lequel le premier étage (302 ; 910 ; 1206) de la pluralité des étages de correction d'erreur est le premier étage de convertisseur analogique-numérique dans le pipeline principal (300 ; 908 ; 1204).

4. Appareil selon la revendication 1, dans lequel l'au moins un de la pluralité des étages de correction d'erreur est le premier étage de correction d'erreur.

5. Appareil selon la revendication 1, dans lequel le module de combinaison (412) est un module d'addition configuré et disposé de manière à ajouter le signal de compensation (408 ; 810) et le signal de sorti de résidu (310).

6. Appareil selon la revendication 1, dans lequel l'au moins un étage fantôme (402-406 ; 502-504 ; 602 ; 702 ; 802-808 ; 930-936 ; 1014-1018 ; 1032-1036 ; 1228-1244) comprend un convertisseur analogique-numérique, et dans lequel le signal de compensation (408 ; 810) est au moins un bit d'erreur numérique.

7. Appareil selon la revendication 1, dans lequel la pluralité des étages de correction d'erreur comprend un premier étage de correction d'erreur (302) et plusieurs étages de correction d'erreur suivants (304-308), le pipeline fantôme (800) comprenant plusieurs étages fantômes (802-808), dans lequel un premier étage fantôme (802) reçoit un premier signal d'erreur de gain du premier étage de correction d'erreur (302) parmi la pluralité des étages de correction d'erreur, le premier étage fantôme (802) étant configuré et disposé de manière à multiplier le premier signal d'erreur de gain par une première constante de gain et à fournir un premier signal fantôme, tandis que chaque étage de pipeline fantôme suivant (804-808) est conçu de manière à recevoir un signal fantôme de l'étage de pipeline fantôme précédent (802-806) et un signal d'erreur de gain de l'étage correspondant (304-308) parmi la pluralité des étages de correction d'erreur, puis à ajouter le signal fantôme et le signal d'erreur de gain et à multiplier cette somme par un facteur de gain, la sortie de la pluralité des étages fantômes (802-808) représentant le signal de compensation (810).

8. Appareil selon la revendication 7, dans lequel le gain de chacun de la pluralité des étages fantômes (802-808) est essentiellement égal au gain de l'amplificateur correspondant contenu dans l'étage de convertisseur analogique-numérique, parmi lesdits plusieurs étages de correction d'erreur (302-308), qui fournit le signal d'erreur de gain à celui-ci.

9. Appareil selon la revendication 7, dans lequel le gain correspondant à l'amplificateur dans chaque étage (302-308) dans le pipeline principal (300) est de deux, et le gain de chaque étage correspondant (802-808) dans le pipeline fantôme (800) est de deux.

10. Appareil selon la revendication 1, dans lequel le pipeline fantôme (900) comprend plusieurs étages fantômes (930-946) et comprend en outre :

   - une partie d'accumulation d'erreurs (904) disposée de manière à recevoir plusieurs signaux d'erreur de gain depuis un sous-ensemble (910-916) de la pluralité des étages de convertisseur analogique-numérique (910-928) contenus dans le pipeline principal (908), afin d'accumuler et de traiter lesdits plusieurs signaux d'erreur de gain reçus et de fournir en sortie un signal de compensation analogique (937) ; et
   - une partie de sortie de compensation analogique-numérique fantôme (906) disposée de manière à recevoir le signal de compensation analogique (937) et à fournir un signal numérique de sortie à M bits ($D_{e6}$-$D_{e10}$)

représentant le signal d'erreur de compensation analogique (937) ;

et dans lequel le module de combinaison comprend un étage d'addition conçu pour ajouter le signal numérique de sortie à M bits ($D_{e6}$-$D_{e10}$) aux M bits les moins importants (D1-D10) fournis par lesdits plusieurs étages de convertisseur analogique-numérique (910-928) dans le pipeline principal (908).

**11.** Appareil selon la revendication 10, dans lequel la partie de sortie de compensation analogique-numérique fantôme (906) du pipeline fantôme (900) comprend un convertisseur analogique-numérique de pipeline.

**12.** Appareil selon la revendication 10, dans lequel la partie de sortie de compensation analogique-numérique fantôme (106) du pipeline fantôme (900) comprend un des éléments choisi dans le groupe comprenant : un convertisseur analogique-numérique flash, un convertisseur analogique-numérique à rangement auxiliaire, un convertisseur analogique-numérique à deux étapes ou multi-étapes, un convertisseur analogique-numérique sigma-delta, un convertisseur analogique-numérique cyclique et algorithmique, un convertisseur analogique-numérique à une ou deux pentes, ou un convertisseur analogique-numérique d'approximation successive, ou une quelconque autre forme de convertisseur analogique-numérique ayant une résolution et une vitesse de sortie appropriées.

**13.** Appareil selon la revendication 1, dans lequel ledit au moins un pipeline fantôme comprend au moins un premier (1002) et un second (1004) pipelines fantômes comprenant chacun une pluralité d'étages de pipeline fantôme (1014-1030 ; 1032-1042), chacun desdits premier et second pipelines fantômes comprenant :

- une partie d'accumulation d'erreur (1006, 1010), dans laquelle la partie d'accumulation d'erreur (1006) du premier pipeline fantôme (1002) est disposée de manière à recevoir plusieurs signaux d'erreur de gain depuis un premier sous-ensemble (910-914) de la pluralité des étages de convertisseur analogique-numérique (910-928) contenus dans le pipeline principal (908), afin d'accumuler et de traiter lesdits plusieurs signaux d'erreur de gain reçus et de fournir en sortie un premier signal de compensation analogique, et dans laquelle la partie d'accumulation d'erreur (1010) du second pipeline fantôme (1004) est disposée de manière à recevoir plusieurs signaux d'erreur de gain depuis un second sous-ensemble (916-920) de la pluralité des étages de convertisseur analogique-numérique (910-928) contenus dans le pipeline principal (908), afin d'accumuler et de traiter lesdits plusieurs signaux d'erreur de gain reçus et de fournir en sortie un second signal de compensation analogique ; et
- une partie de sortie de compensation numérique (1008, 1012), dans laquelle la partie de sortie analogique-numérique (1008) du premier pipeline fantôme (1002) est disposée de manière à recevoir le premier signal de compensation analogique et à fournir un signal numérique de sortie à M bits ($D1_{e6}$-$D1_{e10}$) représentant le premier signal de compensation analogique, et dans laquelle la partie de sortie analogique-numérique (1012) du second pipeline fantôme (1004) est disposée de manière à recevoir le second signal de compensation analogique et à fournir un signal numérique de sortie à L bits ($D2_{e8}$-$D2_{e10}$) représentant le second signal de compensation analogique ;

et dans lequel le module de combinaison comprend un étage d'addition conçu pour ajouter le signal numérique de sortie à M bits ($D1_{e6}$-$D1_{e10}$) aux M bits les moins importants ($D_1$-$D_{10}$) fournis par lesdits plusieurs étages de convertisseur analogique-numérique (910-928) dans le pipeline principal (908), et ajouter le signal numérique de sortie à L bits ($D2_{e8}$-$D2_{e10}$) aux L bits les moins importants ($D_1$-$D_{10}$) fournis par lesdits plusieurs étages de convertisseur analogique-numérique (910-928) dans le pipeline principal (908).

**14.** Appareil selon la revendication 13, dans lequel la partie de sortie de compensation analogique-numérique (1008) du premier pipeline fantôme (1002) comprend un convertisseur analogique-numérique à pipeline.

**15.** Appareil selon la revendication 14, dans lequel la partie de sortie de compensation analogique-numérique (1008) du premier pipeline fantôme (1002) comprend un élément choisi dans le groupe comprenant : un convertisseur analogique-numérique flash, un convertisseur analogique-numérique à rangement auxiliaire, un convertisseur analogique-numérique à deux étapes ou multi-étapes, un convertisseur analogique-numérique sigma-delta, un convertisseur analogique-numérique cyclique et algorithmique, un convertisseur analogique-numérique à une ou deux pentes, ou un convertisseur analogique-numérique d'approximation successive, ou une quelconque autre forme de convertisseur analogique-numérique ayant une résolution et une vitesse de sortie appropriées.

**16.** Appareil selon la revendication 13, dans lequel la partie de sortie de compensation analogique-numérique (1012) du second pipeline fantôme (1004) comprend un convertisseur analogique-numérique à pipeline.

**17.** Appareil selon la revendication 13, dans lequel la partie de sortie de compensation analogique-numérique (1012) du second pipeline fantôme (1004) comprend un élément choisi dans le groupe comprenant : un convertisseur analogique-numérique flash, un convertisseur analogique-numérique à rangement auxiliaire, un convertisseur analogique-numérique à deux étapes ou multi-étapes, un convertisseur analogique-numérique sigma-delta, un convertisseur analogique-numérique cyclique et algorithmique, un convertisseur analogique-numérique à une ou deux pentes, ou un convertisseur analogique-numérique d'approximation successive, ou une quelconque autre forme de convertisseur analogique-numérique ayant une résolution et une vitesse de sortie appropriées.

FIG. 1
(PRIOR ART)

FIG. 2
(PRIOR ART)

FIG. 3

FIG. 4

FIG. 5

FIG. 6

FIG. 7

FIG. 8

FIG. 9

FIG. 10

*FIG. 11*

$V_{in1}$   $\phi_2$   $\phi_2$

$C_1$   1104

$\phi_1$

$C_2$   1206

$\phi_1$   $\phi_2$

1102

$V_{in2}$   $\phi_2$

$\phi_1$

$C_3$   1108

1200

*FIG. 12*

$D_1$   $D_2$   $D_3$   $D_4$   $D_5$   $D_6$   $D_7$   $D_8$   $D_9$   $D_{10}$

1206   1208   1210   1212   1214   1216   1218   1220   1222   1224

1204

| STAGE-1 | STAGE-2 | STAGE-3 | STAGE-4 | STAGE-5 | STAGE-6 | STAGE-7 | STAGE-8 | STAGE-9 | STAGE-10 |

1246   1250   1254   1258   1262   1266   1270   1274   1278

1202

| S1 | S2 | S3 | S4 | S5 | S6 | S7 | S8 | S9 |

1228   1248   1230   1252   1232   1256   1234   1260   1236   1264   1238   1268   1240   1272   1242   1276   1244

$D_{e1}$   $D_{e2}$   $D_{e3}$   $D_{e4}$   $D_{e5}$   $D_{e6}$   $D_{e7}$   $D_{e8}$   $D_{e9}$

**EP 1 255 357 B1**

**REFERENCES CITED IN THE DESCRIPTION**

**Patent documents cited in the description**

- US 6222471 B